# EUROPEAN PATENT APPLICATION

(11) **EP 4 793 260 A2**
(43) Date of publication of application: **19.08.2026**
(21) Application number: 25191222.6
(22) Date of filing: 23.07.2025
(51) Int. Cl.: C04B 37/02, H10W 40/25, C04B 35/645, H10W 90/00

(54) **HEAT DISSIPATION SUBSTRATE FOR A POWER SEMICONDUCTOR MODULE AND A MANUFACTURING METHOD THEREOF**

(30) Priority: 12.02.2025 KR 20250017976; 31.03.2025 KR 20250041716
(71) Applicant: LX Semicon Co., Ltd., Daejeon 34027 (KR)
(72) Inventor: HAN, Young Soo, 34027 Daejeon (KR); CHO, Nam Tae, 34027 Daejeon (KR)
(74) Representative: Ter Meer Steinmeister & Partner

(57) **Abstract**

A heat dissipation substrate for a power semiconductor module according to an embodiment may include an insulating substrate; a bonding metal layer disposed on the insulating substrate; a diffusion metal layer disposed on the bonding metal layer; and a metal plate disposed on the diffusion metal layer, wherein at least one of the bonding metal layer and the diffusion metal layer has a uniform thickness and/or a constant thermal expansion coefficient in a direction parallel to the surface of the insulating substrate (210).

## Description

### BACKGROUND

### Field of the Disclosure

The embodiment relates to a substrate for a heat dissipation substrate, a heat dissipation substrate for a power semiconductor module, a power semiconductor module including the same, a power convertor including the same, and a manufacturing method thereof.

### Description of the Background

Recently, eco-friendly cars based on electricity or hydrogen are in the spotlight instead of fossil fuel-based internal combustion engine cars, and numerous power semiconductor devices are used in these eco-friendly cars. Eco-friendly cars include hybrid electric vehicles (HEVs), plug-in hybrid electric vehicles (PHEVs), electric vehicles (EVs), fuel cell electric vehicles (PCEVs), etc.

In addition to eco-friendly cars, power semiconductors are used in various electric and electronic devices such as electric vehicle chargers, energy storage devices, power supply devices, and railways.

Previously, silicon (Si) power semiconductor devices were widely used, but as Si power semiconductors reached their physical limits, research on wide bandgap (WBG) power semiconductors such as silicon carbide (SiC) or gallium nitride (GaN) to replace them is actively being conducted.

WBG power semiconductor devices have a bandgap energy approximately three times higher than Si power semiconductor devices, a dielectric breakdown field approximately ten times higher than Si power semiconductor devices, and a thermal conductivity approximately three times higher than Si power semiconductor devices. Due to these excellent characteristics, WBG power semiconductor devices may be operated in high temperature and high voltage environments, and have the advantage of high switching speeds and low switching losses.

For example, Si-based power semiconductor modules used to perform power conversion (DC↔AC), motor drive switching, control, etc. in conventional electric vehicles, hybrid electric vehicles, etc. were operated in a temperature environment of about 150°C, but recently, due to the demand for increased switching performance and power density, research is actively being conducted on wide band gap (WBG)-based power semiconductor devices such as SiC or GaN that may operate at a usage temperature of about 300°C or higher, for example, at about 300~700°C.

Meanwhile, heat generated from power semiconductors causes thermo-mechanical stress in each part of the power semiconductor module, and the life of the junction and power semiconductor devices may be deteriorated due to thermal fatigue at the junction. Therefore, the reliability design of power semiconductor modules that appropriately releases the heat generated from the power semiconductor devices through the heat dissipation substrate and maintains the junction temperature of the power semiconductor devices below an appropriate temperature is very important.

Meanwhile, the heat dissipation substrate for power semiconductors not only has the function of transferring heat generated during the operation of power semiconductor devices to the outside, but also has an important function of electrically connecting power semiconductor devices by forming a circuit pattern on one side of the heat dissipation substrate.

Conventional heat dissipation substrates for power semiconductors may be classified into the DBC (direct bonded copper) method and the AMB (active metal brazing) method according to the bonding method. The DBC method is a method of forming an oxide film on a copper (Cu) layer and then directly bonding it to a ceramic substrate. The AMB method is a method of performing brazing by interposing a paste containing relatively low melting point metal particles between the base metal and a ceramic substrate.

However, recently, 1200V, 200A high-voltage/high-power SiC power conversion modules are being used for performance improvement of hybrid and electric vehicles and autonomous vehicles, and the operating temperature of power semiconductor devices during operation of these high-performance electric vehicles is required to be implemented at an average of 300°C or higher, and SiC power conversion modules are facing an ultra-high temperature usage state with an instantaneous maximum operating temperature of 350°C or higher.

In such an ultra-high temperature, high voltage, and high current operating environment, existing bonding materials may be re-melted, and heat trapping phenomenon may occur due to pores existing in the bonding part, which may rapidly deteriorate the life of the power semiconductor module. For example, cracks may occur due to defects induced at the interface between the ceramic substrate of the heat dissipation substrate and the copper (Cu) sheet, and cracks induced in such a heat dissipation substrate may cause thermal runaway, leading to the destruction of the power semiconductor device.

For example, if the heat dissipation performance is reduced due to cracks, etc. in the heat dissipation substrate, temperature of the power semiconductor module case may increase. At this time, if the heat generation exceeds the heat dissipation performance due to the rapid temperature increase (heat generation state > heat dissipation performance), the thermal equilibrium state (heat generation state < heat dissipation performance) according to the thermal design is not maintained and the heat generation continues to increase. As a result, the leakage current continues to increase, which ultimately leads to the destruction of the power semiconductor module itself.

In particular, in the case where the power semiconductor module deteriorates in an ultra-high temperature operating temperature environment, the destruction of the power semiconductor device due to malfunction of the power semiconductor module mounted on the vehicle may have a serious impact on the driver's safety.

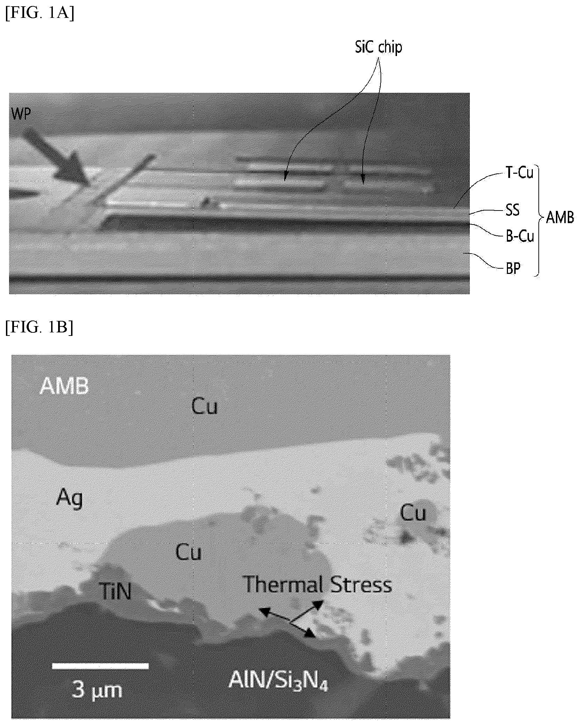

Meanwhile, FIG. 1A is a photograph showing warpage (WP) after the AMB heat dissipation substrate according to the conventional technology is bonded to the base plate (BP), and FIG. 1B is an SEM (Scanning Electron Microscope) photograph of the brazing bonding interface according to the conventional AMB technology.

The coefficients of thermal expansion of the insulating substrate (SS), of the Cu plates, and of SiC that together constitute the conventional AMB heat sink substrate are significantly different. For example, the coefficient of thermal expansion of the silicon nitride (Si₃N₄) insulating substrate (SS) is 2.6 (ppm/K), the coefficient of thermal expansion of the upper plate copper (T-Cu) or lower plate copper (B-Cu) is 17.7 (ppm/K), and the coefficient of thermal expansion of the SiC chip is 4.44 (ppm/K). In addition, the coefficient of thermal expansion of the aluminum nitride (AlN) base substrate (BP) is 4.6 (ppm/K).

In the conventional AMB heat sink substrate, warpage (WP) occurs due to the difference in the coefficient of thermal expansion of the components that constitute the power semiconductor module in an ultra-high temperature operating temperature environment of 300°C or higher, which may cause malfunction of the power semiconductor module.

In particular, in the conventional AMB heat dissipation substrate, since the paste, which is a mixture of metal particles, may be screen-printed, the intermediate Ti-Ag-Cu alloy interface layer may not be formed with a uniform thickness due to the limitation of the process capability of screen printing. And since the paste is a mixture, an interface may be formed between different materials in the final product.

As a result, referring to FIG. 1B, when thermal expansion occurs, thermal stress occurs not only on the side of the interface but also in the vertical direction, which reduces thermal shock reliability and causes separation of the ceramic and copper (Cu) plates due to a destruction phenomenon at the interface.

### SUMMARY

Accordingly, one of the technical objects of the present disclosure is to solve a problem of separation of an insulating substrate, in particular of a ceramic substrate, and a metal plates, e.g. a copper (Cu) plates, due to a destruction phenomenon at the interface, which reduces thermal shock reliability and causes thermal stress due to a difference in the thermal expansion coefficients of the insulating substrate, the upper metal plate, and the lower metal plate that constitute the heat dissipation substrate.

A further object of the present disclosure is to solve the problem of each layer being peeled off due to uneven thermal stress in the heat dissipation substrate.

A further object of the present disclosure is to improve the thermal shock reliability of the heat dissipation substrate.

A further object of the present disclosure is to solve the problem of cracks occurring at the bonding interface of the heat dissipation substrate.

The technical objects of the present disclosure are not limited to those described in this item and include those that may be understood through the description of the invention. At least one of the technical objects is solved by the features of the independent claim(s).

According to an aspect of the present disclosure, a heat dissipation substrate for a power semiconductor module includes: an insulating substrate; a bonding metal layer disposed on the insulating substrate; a diffusion metal layer disposed on the bonding metal layer; and a metal plate disposed on the diffusion metal layer.

According to a further aspect of the present disclosure, a heat dissipation substrate for a power semiconductor module includes: an insulating substrate; a bonding metal layer disposed on a first surface the insulating substrate; a diffusion metal layer disposed on the bonding metal layer; a metal plate disposed on the diffusion metal layer; a further bonding metal layer disposed on a second surface the insulating substrate which is opposite to the first surface; a further diffusion metal layer disposed on the further bonding metal layer; a further metal plate disposed on the further diffusion metal layer. The bonding metal layer and the further bonding metal layer may be identical to each other. The diffusion metal layer and the further diffusion metal layer may be identical to each other. The metal plate and the further metal plate may be identical to each other.

The heat dissipation substrate according to any one of these aspects may include one or more of the following features:
At least one of or each of the bonding metal layer and the diffusion metal layer may have a uniform thickness.

At least one of or each of the bonding metal layer and the diffusion metal layer may have a uniform or (spatially) constant coefficient of thermal expansion, e.g. in a direction parallel to a surface of the insulating substrate.

The bonding metal layer and/or the diffusion metal layer may be disposed by sputtering.

The bonding metal layer and/or the diffusion metal layer may be formed by sputtering and a hot press process. The hot press process may be a process including compression and heating.

A coefficient of thermal expansion (thermal expansion coefficient) of the bonding metal layer may be greater than that of the insulating substrate.

A coefficient of thermal expansion of the diffusion metal layer may be greater than that of the bonding metal layer.

The bonding metal layer may be an alloy of a material of the insulating substrate. That is, the bonding metal layer may be an alloy including a chemical element of the insulating substrate.

The bonding metal layer may include Ti or consist of TiN.

The diffusion metal layer may be an alloy of a material of the metal plate. That is, the diffusion metal layer may be an alloy including a metal of the metal plate.

The diffusion metal layer may include or consist of a metal alloy, e.g. an Al alloy, an Ag alloy, a Sn alloy or a CuAl alloy.

The metal plate may include or consist of Cu.

The insulating substrate may include or consist of polycrystalline material, in particular non-oxide ceramic material. The insulating substrate may include or consist of AlN and/or Si₃N₄, and/or sapphire.

The insulating substrate may include at least two substrates stacked one on the other.

The insulating substrate may include a first insulating substrate, a second insulating substrate disposed on the first insulating substrate, and a third insulating substrate disposed on the second insulating substrate. The first insulating substrate may include or consist of Si₃N₄. The second insulating substrate may include or consist of AlN.

A coefficient of thermal expansion of the second insulating substrate may be greater than that of the first insulating substrate.

A coefficient of thermal expansion of the third insulating substrate may be greater than that of the second insulating substrate.

The bonding metal layer may form an alloy with a material of the insulating substrate. The diffusion metal layer may form an alloy with material of the metal plate.

At least one of or each of the insulating substrate, the bonding metal layer, and the diffusion metal layer may have a constant coefficient of thermal expansion in the horizontal direction.

According to a further aspect of the present disclosure, a method for manufacturing a heat dissipation substrate for a power semiconductor module, in particular a heat dissipation substrate according to any one of the aspects and embodiments above, includes: a step of forming a first bonding metal layer by sputtering on an insulating substrate; a step of forming a first diffusion metal layer by sputtering on the first bonding metal layer; a step of arranging a metal plate on the first diffusion metal layer; and a step of thermally compressing the insulating substrate, the first bonding metal layer, the first diffusion metal layer, and the metal plate ("hot press process step"). The thermally compressing step (i.e. the hot press process step) may be performed at a temperature higher than a melting point temperature of the first diffusion metal layer.

The thermally compressing step (i.e. the hot press process step) may include a step of compressing before applying heat, e.g. before heating to a temperature above the melting point temperature of the first diffusion metal layer. The compressing step may be continued until a temperature is reached at which the metal plate and the insulating substrate are bonded.

The thermally compressing step (i.e. the hot press process step) may include heating to a temperature above 800°C, in particular to a temperature between 900°C and 1100°C.

The first bonding metal layer may be diffused into the insulating substrate to form a second bonding layer.

The first diffusion metal layer may be diffused into the metal plate to form a second diffusion metal layer.

The bonding metal layer may be configured to form a first bonding metal layer having a first alloy layer with a material of the insulating substrate.

The first bonding metal layer may be formed through diffusion of material of the bonding metal layer and material of insulating substrate.

The first bonding metal layer may comprise a TiN alloy layer.

The diffusion metal layer may be configured to form second diffusion metal layer having a second alloy layer with a material of the metal plate.

The second diffusion metal layer may be formed through diffusion of material of the diffusion metal layer and material of metal plate.

The second diffusion metal layer may comprise a Cu-Al alloy layer.

According to a further aspect of the present disclosure, a power convertor includes a power semiconductor module having the heat dissipation substrate according to any one of the herein described aspects and embodiments.

The heat dissipation substrate for the power semiconductor according to the embodiment can solve the problem of separation of an insulating substrate and metal plates due to a fracture phenomenon at the interface as thermal stress occurs due to a difference in thermal expansion coefficients of the insulating substrate, the upper metal plate, and the lower metal plate constituting the heat dissipation substrate, thereby lowering thermal shock reliability.

For example, according to the embodiment, the insulating substrate and the metal plate joint may have a uniform thickness, and since the joint may have a uniform coefficient of thermal expansion, thermal stress can be prevented in the vertical direction, so that peeling of the joint layer can be prevented, and there is a technical effect that may improve thermal shock reliability.

For example, in the embodiment, the coefficient of thermal expansion is sequentially changed from the diffusion metal layer to the insulating substrate, so that thermal stress at each interface can be uniformly distributed. So, thermal shock reliability can be improved, and cracks can be prevented at the joint interface.

In addition, the embodiment has a technical effect that can prevent peeling of each layer of the heat dissipation substrate due to uneven thermal stress.

For example, in the embodiment, since each layer may have a uniform coefficient of thermal expansion, thermal stress can be prevented in the vertical direction, so that peeling of each layer can be prevented.

In addition, the embodiment has a technical effect that can prevent warpage of the heat dissipation substrate.

For example, the embodiment can prevent the warpage problem of the heat dissipation substrate as the coefficient of thermal expansion in the horizontal direction is constant.

The technical effects of the embodiment are not limited to those described in this item and include those that may be understood through the description of the invention.

### BRIEF DESCRIPTION OF THE DRAWINGS

FIG. 1A is a photograph showing warpage after an AMB heat dissipation substrate according to a conventional technique is bonded to a base plate (BP).
FIG. 1B is an SEM photograph of a brazing bonding interface according to a conventional AMB technique.
FIG. 2 is a cross-sectional view of a power semiconductor module (500) including a heat dissipation substrate for power semiconductors according to an embodiment.
FIG. 3 is a manufacturing process diagram of a power semiconductor module (501) including a heat dissipation substrate for power semiconductors according to the first embodiment.
FIG. 4 is a process flow diagram of a manufacturing process of a heat dissipation substrate for power semiconductors according to an embodiment.
FIGs 5A and 5B are manufacturing process diagrams of a heat dissipation substrate for power semiconductors according to an embodiment.
FIG. 6 is a cross-sectional view of a heat dissipation substrate for power semiconductors according to an embodiment.
FIG. 7 is a cross-sectional view showing area B of FIG. 6 in detail.

### DETAILED DESCRIPTION

Hereinafter, the invention according to an embodiment for solving the above problem will be described in more detail with reference to the drawings.

The suffixes "module" and "part" used for components in the following description are given simply for the convenience of writing this specification, and do not themselves have a particularly important meaning or role. Therefore, the "module" and "part" may be used interchangeably.

Terms including ordinal numbers such as first, second, etc. may be used to describe various components, but the components are not limited by the terms. The terms are used only for the purpose of distinguishing one component from another.

Singular expressions include plural expressions unless the context clearly indicates otherwise.

In the present application, terms such as "include," or "have" are intended to specify the presence of features, numbers, steps, operations, components, parts, or combinations thereof described in the specification, and should be understood as not excluding in advance the possibility of the presence or addition of one or more other features, numbers, steps, operations, components, parts, or combinations thereof.

In an embodiment, the power semiconductor module may be used in an inverter or converter for an automobile, computer, home appliance, solar power, smart grid, etc. In addition, the power semiconductor module according to the embodiment may be applied to various electric and electronic devices such as an electric vehicle charger, power supply device, or railway in addition to an eco-friendly automobile.

In addition, the heat dissipation substrate for a power semiconductor according to the embodiment may be mounted and used in a power semiconductor module mounted in various electric and electronic devices such as an inverter or converter for an automobile, computer, home appliance, solar power, smart grid, etc.

In the embodiment, the power semiconductor device may include one power semiconductor module or multiple power semiconductor modules. In addition, the power semiconductor module may include multiple power semiconductor devices.

In the embodiment below, the power semiconductor device describes an inverter for driving a motor for an automobile, but the power semiconductor device of the embodiment may be applied to inverters or converters in various technical fields described above. Here, the automobile may include a hybrid vehicle (HEV), a plug-in hybrid vehicle (PHEV), an electric vehicle (EV), a fuel cell vehicle (PCEV), etc. In the description of the embodiment below, the switching element and the power semiconductor device may be used interchangeably.

### <Power semiconductor module including a heat dissipation substrate>

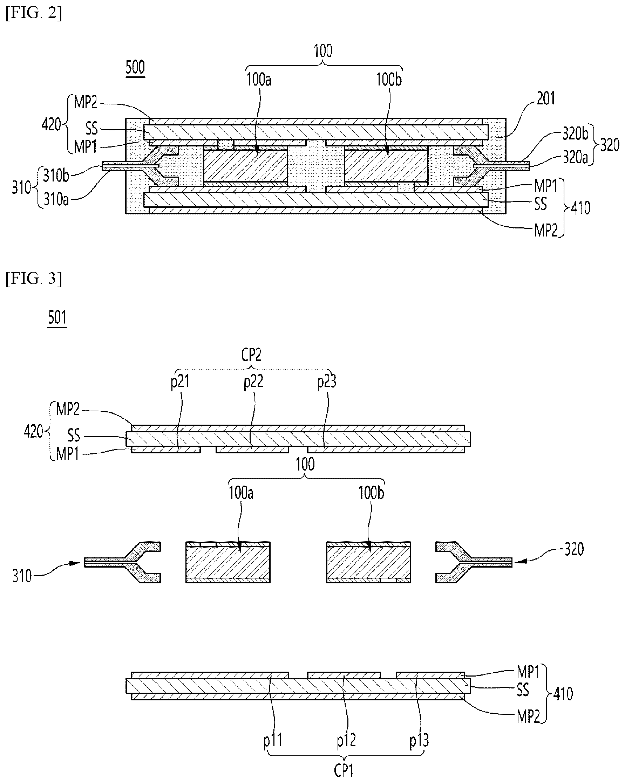

FIG. 2 is a cross-sectional view of a power semiconductor module (500) including a heat dissipation substrate for a power semiconductor according to the embodiment, and FIG. 3 is a manufacturing process drawing of a power semiconductor module (501) including a heat dissipation substrate for a power semiconductor according to the first embodiment.

Referring to FIG. 2, a power semiconductor module (500) according to an embodiment may include a first heat dissipation substrate (410), a second heat dissipation substrate (420), a power semiconductor device (100), a first lead frame (310), and a second lead frame (320), and may be packaged by a mold (201). The mold (201) may include an EMC (Epoxy Molding Compound), but is not limited thereto. The power semiconductor device (100) may include a first power semiconductor device (100a) and a second power semiconductor device (100b).

For example, referring to FIG. 3, a first lead frame (310), a second lead frame (320), and single or multiple power semiconductor devices (100a, 100b) are disposed between a first heat dissipation substrate (410), a second heat dissipation substrate (420), and then pressed to manufacture a power semiconductor module (501) according to the first embodiment.

The power semiconductor device (100), the first heat dissipation substrate (410), and the second heat dissipation substrate (420) may be bonded through a predetermined adhesive member (not shown).

For example, the first and second heat dissipation substrates (410, 420) may be bonded to the power semiconductor device (100) through soldering, sintering bonding, transient liquid phase bonding (TLP bonding) or ultrasonic bonding, etc.

In the embodiment, the first and second heat dissipation substrates (410, 420) may be respectively disposed on the lower and upper sides of the power semiconductor module (500), but are not limited thereto.

The first heat dissipation substrate (410) may include a first metal plate (MP1), an insulating substrate (SS), and a second metal plate (MP2).

The insulating substrate (SS) may electrically insulate the first metal plate (MP1) and the second metal plate (MP2). The insulating substrate (SS) may be or include a ceramic substrate, in particular a non-oxide ceramic substrate. The insulating substrate (SS) may include a polycrystalline insulating substrate made of a ceramic material, in particular of a ceramic material having high thermal conductivity. For example, the insulating substrate (SS) may include or be one of AlN or Si₃N₄, but is not limited thereto. In addition, the insulating substrate (SS) may include a single-crystal substrate such as a sapphire substrate.

Hereinafter, the insulating substrate (SS) is described as a polycrystalline substrate made of a ceramic material, but is not limited thereto, and may also include a single-crystal substrate.

The first metal plate (MP1) and the second metal plate (MP2) may include a Cu-based metal, but is not limited thereto.

The second metal plate (MP2) may have one side in contact with the insulating substrate (SS) and may dissipate heat to the other side. A heat dissipation means including a cooling medium may be arranged in close proximity to the other side of the second metal plate (MP2).

Referring to FIG. 3, the first metal plate (MP1) disposed on the lower side of the power semiconductor device (100) may include a first circuit pattern (CP1) formed by a patterning process such as etching, and the first circuit pattern (CP1) may be electrically connected to the electrodes of the power semiconductor device (100).

For example, the first circuit pattern (CP1) may include a first-first circuit pattern (p11), a first-second circuit pattern (p12), and a first-third circuit pattern (p13) that are electrically separated, and may be electrically connected to the first power semiconductor device (100a) and the second power semiconductor device (100b), as in FIG. 2.

In addition, the second heat dissipation substrate (420) may also include a first metal plate (MP1), an insulating substrate (SS), and a second metal plate (MP2). The second heat dissipation substrate (420) may adopt the technical features of the first heat dissipation substrate (410).

For example, the first metal plate (MP1) disposed on the upper side of the power semiconductor device (100) may include a second circuit pattern (CP2) that is formed by a patterning process such as etching and is electrically separated. The second circuit pattern (CP2) may include a second-first circuit pattern (p21), a second-second circuit pattern (p22), and a second-third circuit pattern (p23), and may be electrically connected to the first power semiconductor device (100a) and the second power semiconductor device (100b) as shown in FIG. 2, respectively.

Referring to FIG. 2, Each one end of the first lead frame (310) and the second lead frame (320) may be electrically connected to the power semiconductor device (100), and each other end may be connected to an external connection terminal. The external connection terminal may include an input power source, a motor, or an inverter controller.

For example, the first lead frame (310) and the second lead frame (320) may be electrically connected to the power semiconductor device (100) through the first heat dissipation substrate (410) and the second heat dissipation substrate (420).

### <Manufacturing process of a heat dissipation substrate for a power semiconductor>

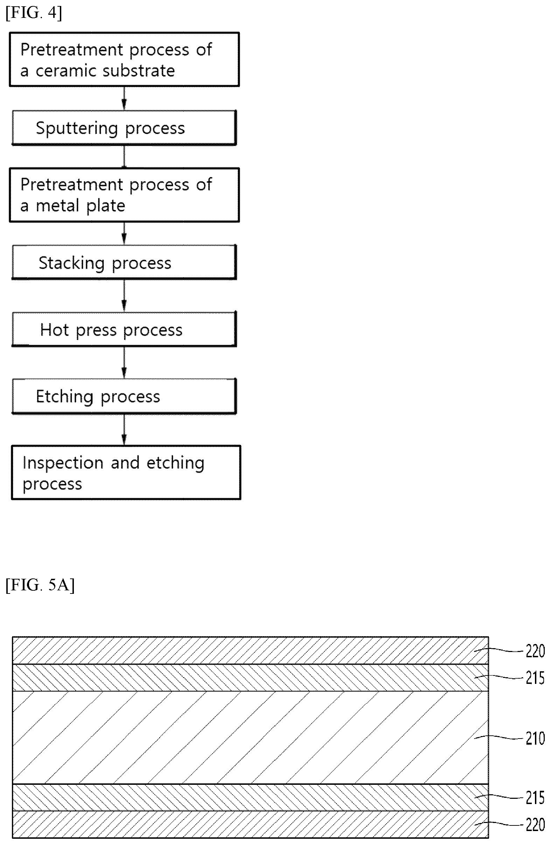

FIG. 4 is a schematic process flow diagram of a manufacturing process of a heat dissipation substrate for a power semiconductor according to an embodiment.

The manufacturing process of the heat dissipation substrate for power semiconductors according to the embodiment may include a pretreatment process of the insulating substrate, a sputtering process, a lamination or stacking process of the insulating substrate and the metal plate, a hot press process of the insulating substrate and the metal plate, an etching process of the heat dissipation substrate, and an inspection and cutting process of the heat dissipation substrate. It is noted that one or more of these steps may be omitted.

The overall manufacturing process of the heat dissipation substrate for power semiconductors according to the embodiment may be controlled by a control unit (not shown) of a central server, and the central server may include a data storage unit (not shown).

The insulating substrate for manufacturing the heat dissipation substrate according to the embodiment below is described as an example of a polycrystalline ceramic substrate, but is not limited thereto, and may include a single-crystal substrate such as a sapphire substrate.

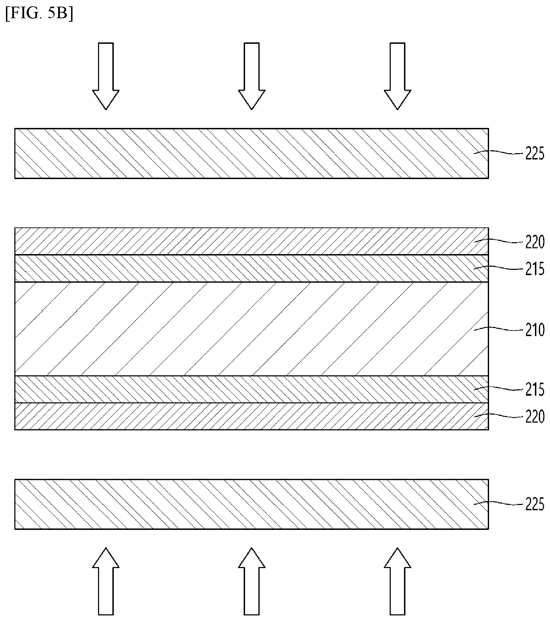

FIG. 5A and FIG. 5B are drawings showing a method of manufacturing a heat dissipation substrate according to the embodiment.

First, referring to FIG. 5A, a first bonding metal layer (215) may be formed on an insulating substrate (210) by sputtering. The first bonding metal layer (215) may include Ti, but is not limited thereto. In addition, the first bonding metal layer (215) may be formed with a uniform thickness.

In addition, a first diffusion metal layer (220) may be formed on the first bonding metal layer (215). The first diffusion metal layer (220) may be formed by sputtering. The first diffusion metal layer (220) may be formed with a uniform thickness.

Thicknesses of the first diffusion metal layer (220) and the first bonding metal layer (215) may be formed differently.

The first diffusion metal layer (220) may include a material having a melting point lower than a temperature of a hot press process for subsequent bonding. For example, for example, the first diffusion metal layer (220) may be at least one of Al, Ag or Sn, but is not limited thereto.

At this time, a thermal expansion coefficient of the first diffusion metal layer (220) may be greater than that of the first bonding metal layer (215). In addition, the thermal expansion coefficient of the first bonding metal layer (215) may be greater than that of the insulating substrate (210).

In addition, after the first bonding metal layer (215) and the first diffusion metal layer (220) are formed on one surface of the insulating substrate (210), the insulating substrate (210) may be turned over and another first bonding metal layer (215) and another first diffusion metal layer (220) may be sequentially sputtered on the opposite surface thereof.

Referring to FIG. 5B, the heat dissipation substrate formed through sputtering in FIG. 5A may undergo a hot press process together with the metal plate (225). A temperature of the hot press may be in the range of about 900°C to 1100°C, but is not limited thereto. The temperature of the hot press may be higher than the melting point of the first diffusion metal layer (220).

In the hot press process, a metal plate (225) may be disposed on the first diffusion metal layer (220). The metal plate (225) may include a Cu-based metal, but is not limited thereto. The metal plate (225) may be placed so as to have a uniform thickness.

Meanwhile, heat and pressure may be applied to the metal plate (225) and the insulating substrate (210) in the hot press process. At this time, the pressure may be applied before the time when the heat is applied, but is not limited thereto.

In addition, the pressure may be applied before the temperature at which the insulating substrate (210) of the hot press and the metal plate (225) are bonded. In addition, the embodiment may be applied with a uniform pressure until after the temperature of the hot press process is reached.

According to the embodiment, the first diffusion metal layer (220) may be melted by the pressure applied above the melting point of the first diffusion metal layer (220) during the hot press process and exists as a molten liquid having a uniform thickness between the metal plate (225) and the first bonding metal layer (215), thereby forming a bonding layer having a uniform thickness and composition.

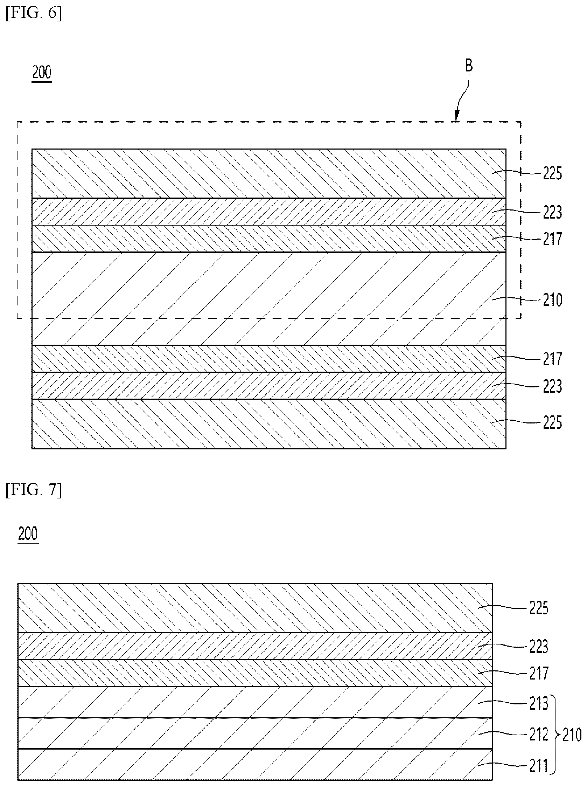

For example, during the hot press process, the first bonding metal layer (215) may form a second bonding metal layer (217) (see FIG. 6), which is an alloy layer, through diffusion. For example, when the first bonding metal layer (215) may include Ti, the N material of the insulating substrate (210) may be diffused to form a second bonding metal layer (217) of a TiN alloy. At this time, some Ti material may remain, but is not limited thereto.

In addition, the first diffusion metal layer (220) may be combined with the material of the metal plate (225) through diffusion to form a second diffusion metal layer (223) (see FIG. 6) which is an alloy layer. For example, when the first diffusion metal layer (220) may include Al, Al may be diffused into the metal plate (225) to form a second diffusion metal layer (223) which is a Cu-Al alloy layer. At this time, some Al material may remain, but is not limited thereto.

The bonding temperature at which the alloy layer is formed in the first diffusion metal layer (220) and the first bonding metal layer (215) may be in the range of about 900°C to 1100°C, but is not limited thereto.

Meanwhile, since the hot press process uniformly applies pressure before the bonding temperature, the material of the first diffusion metal layer (220) may be uniformly diffused and distributed over the entire surface. Accordingly, the second diffusion metal layer (223) of the diffusion metal layer may be formed as a uniform layer in the horizontal direction rather than being randomly formed in an island shape.

Meanwhile, the hot press process sequentially proceeds from the melting of the first diffusion metal layer (220) to form the second bonding metal layer (217) and the second diffusion metal layer (223), each having a uniform composition, and as a result, forms a layered bonding layer. According to an embodiment, the formation of the second bonding metal layer (217) and the second diffusion metal layer (223) in a direction parallel to the surface of the ceramic substrate (210) is characterized by applying a uniform pressure acting in a direction perpendicular to the surface of the ceramic substrate (210), and a sequential interface reaction is performed to form a layered alloy layer, and each alloy layer may have a uniform composition.

FIG. 6 is a cross-sectional view of a heat dissipation substrate (200) for power semiconductors according to an embodiment. Referring to FIG. 6, the heat dissipation substrate (200) may be manufactured through the sputtering process in FIG. 5A and the hot press process in FIG. 5B. The heat dissipation substrate (200) may have the second bonding metal layer (217) disposed on one surface of the insulating substrate (210). In addition, the second diffusion metal layer (223) may be disposed on the second bonding metal layer (217). In addition, a metal plate (225) may be disposed on the second diffusion metal layer (223).

The second bonding metal layer (217), the second diffusion metal layer (223), and the metal plate (225) may be arranged identically on a surface opposite to the one surface of the insulating substrate (210).

The second bonding metal layer (217) may include an alloy formed by diffusing the nitrogen (N) material of the insulating substrate (210) into the first bonding metal layer (215) of FIG. 5B. Accordingly, the second bonding metal layer (217) may include TiN, but is not limited thereto.

In addition, the second diffusion metal layer (223) may include an alloy layer formed by diffusing the material of the metal plate (225) into the first diffusion metal layer (220) of FIG. 5B and. For example, the second diffusion metal layer (223) may include a Cu-Al alloy, but is not limited thereto.

Meanwhile, in the conventional AMB heat dissipation substrate, thermal stress occurs randomly due to the non-uniformity of the material at the interface of each layer. Accordingly, a problem occurs in which thermal stress acts in the vertical direction at the interface, causing each layer to peel off.

For example, in the conventional AMB heat dissipation substrate, since the paste, which is a mixture of metal particles, is screen-printed, the intermediate Ti-Ag-Cu alloy interface layer is not formed with a uniform thickness due to the limitations of the process capability of screen printing, and in particular, it may be formed in an island shape that is separated from each other and clumped together without forming a single layer. In addition, since the paste in the conventional AMB heat dissipation substrate is a mixture, an interface is formed between different materials in the final product. Due to this, when thermal expansion occurs, thermal stress occurs not only on the side of the interface but also in the vertical direction, which reduces the reliability of thermal shock, and there is a problem that the ceramic and copper (Cu) plate are separated due to the destruction phenomenon at the interface.

Specifically, the Ti-Ag-Cu alloy interface layer, which is an intermediate material in the conventional AMB heat dissipation substrate, has limitations in forming a film with a relatively uniform thickness due to the coating process using screen printing. In particular, individual metal particles undergo individual reactions in the high-temperature heat treatment process, so that the interface exists in the form of a non-uniform mixture after the bonding process. And the TiN, Ag, and Cu components are separated and formed into individual areas. For example, as shown in FIG. 1B, the direction of the interface formed by TiN, Ag, and Cu is randomly formed, and the direction of the thermal stress caused by the difference in the thermal expansion coefficient of each composition at the interface is randomly generated, so in the case of thermal stress acting in the vertical direction with the ceramic substrate surface, it acts as a factor that reduces the reliability of the substrate.

Meanwhile, in the embodiment, the second bonding metal layer (217) is formed by sputtering and pressure may be applied before the bonding temperature during the hot press process. Accordingly, the second bonding metal layer (217) can have a uniform thickness and uniform composition over the entire area. Accordingly, the second bonding metal layer (217) may have a constant thermal expansion coefficient in the horizontal direction.

In addition, the second diffusion metal layer (223) may be formed by sputtering, and pressure may be applied before the bonding temperature during the hot press process. Accordingly, the second diffusion metal layer (223) may have a uniform thickness and composition in the entire area. Accordingly, the second diffusion metal layer (223) may have a constant thermal expansion coefficient in the horizontal direction.

Therefore, since the embodiment can have each layer forming the heat dissipation substrate (200) having a constant thermal expansion coefficient in the horizontal direction, thermal stress at each interface may be minimized. In addition, since the embodiment has each interface formed uniformly, it has a special technical effect of preventing thermal stress transfer in the vertical direction, thereby preventing peeling of the heat dissipation substrate.

In addition, the embodiment has a technical effect that the thermal stress is uniformly distributed as the thermal expansion coefficient of each layer of the heat dissipation substrate is formed to be constant, thereby improving the thermal shock reliability of the heat dissipation substrate.

FIG. 7 is a cross-sectional view showing the B region of FIG. 6 in detail.

Referring to FIG. 7, the insulating substrate (210) may include a first insulating substrate (211), a second insulating substrate (212), and a third insulating substrate (213). The second insulating substrate (212) may be disposed on one surface of the first insulating substrate (211), and the third insulating substrate (213) may be disposed on the second insulating substrate (212). The second insulating substrate (212) and the third insulating substrate (213) may arranged identically on a surface opposite to the one surface of the first insulating substrate (211).

At this time, the thermal expansion coefficient of the third insulating substrate (213) may be greater than the thermal expansion coefficient of the second insulating substrate (212). In addition, the thermal expansion coefficient of the second insulating substrate (212) may be greater than the thermal expansion coefficient of the first insulating substrate (211).

For example, the first insulating substrate (211) may be Si₃N₄, but is not limited thereto. In addition, the second insulating substrate (212) may be AlN, but is not limited thereto.

In addition, the thermal expansion coefficient of the third insulating substrate (213) may be smaller than the thermal expansion coefficient of the second bonding metal layer (217). In addition, the thermal expansion coefficient of the insulating substrate (210) may be smaller than the thermal expansion coefficient of the second bonding metal layer (217).

Accordingly, in the embodiment, the thermal expansion coefficient may sequentially decrease from the second diffusion metal layer (223) to the first insulating substrate (211). Accordingly, the embodiment has a technical effect that thermal stress may be uniformly distributed at each interface.

The heat dissipation substrate for power semiconductors according to the embodiment has a technical effect that may improve thermal shock reliability.

For example, the embodiment has a thermal expansion coefficient that sequentially decreases from the diffusion metal layer to the insulating substrate, so that thermal stress may be uniformly distributed at each interface, thereby improving thermal shock reliability and preventing cracks from occurring at the bonding interface.

In addition, the embodiment has a technical effect that can prevent each layer of the heat dissipation substrate from being delaminated due to non-uniformity of thermal stress.

For example, since the embodiment may have a uniform thermal expansion coefficient for each layer, thermal stress can be prevented in the vertical direction, so that delamination of each layer can be prevented.

In addition, the embodiment has a technical effect that can prevent warpage of the heat dissipation substrate.

For example, the embodiment can prevent the warpage problem of the heat dissipation substrate as the coefficient of thermal expansion in the horizontal direction is constant.

Although the above has been described with reference to the embodiment of the present invention, it will be easily understood by those skilled in the art that the present invention may be variously modified and changed within the scope that does not depart from the scope of the present invention described in the scope of the following patent claims.

### [Reference numbers]

210: insulating substrate, 211: first insulating substrate
212: second insulating substrate, 213: third insulating substrate
215 first bonding metal layer, 217: second bonding metal layer
220: first diffusion metal layer, 223: second diffusion metal layer
225: metal plate

## Claims

1. A heat dissipation substrate for a power semiconductor module, comprising:
an insulating substrate (210);
a bonding metal layer (217) on a surface of the insulating substrate (210);
a diffusion metal layer (223) on the bonding metal layer (217); and
a metal plate (225) disposed on the diffusion metal layer (223),
wherein at least one of the bonding metal layer (215) and the diffusion metal layer (220) has a uniform thickness and/or a constant thermal expansion coefficient in a direction parallel to the surface of the insulating substrate (210).

2. The heat dissipation substrate according to claim 1, wherein a thermal expansion coefficient of the bonding metal layer (217) is greater than a thermal expansion coefficient of the insulating substrate (210); and/or
wherein a thermal expansion coefficient of the diffusion metal layer (223) is greater than a thermal expansion coefficient of the bonding metal layer (217).

3. The heat dissipation substrate according to any one of the preceding claims, wherein the bonding metal layer (217) is an alloy of a material of the insulating substrate (210); and/or
wherein the bonding metal layer (217) includes Ti or consists of a TiN alloy.

4. The heat dissipation substrate according to any one of the preceding claims, wherein the diffusion metal layer (223) is an alloy of a metal of the metal plate (225); and/or wherein the diffusion metal layer (223) includes Al, Ag, or Sn or consists of a CuAl alloy.

5. The heat dissipation substrate according to any one of the preceding claims, wherein the insulating substrate (210) includes a polycrystalline material; and/or wherein the insulating substrate (210) includes AlN and/or Si₃N₄.

6. The heat dissipation substrate according to any one of the preceding claims, wherein the insulating substrate (210) comprises a first insulating substrate (211), a second insulating substrate (212) disposed on the first insulating substrate (211), and a third insulating substrate (213) disposed on the second insulating substrate (212), and wherein a thermal expansion coefficient of the second insulating substrate (212) is greater than that of the first insulating substrate (211) and/or a thermal expansion coefficient of the third insulating substrate is greater than that of the second insulating substrate (212).

7. The heat dissipation substrate according to any one of the preceding claims, wherein each of the insulating substrate (210), the bonding metal layer (217), and the diffusion metal layer (223) has a constant thermal expansion coefficient in the direction parallel to the surface of the insulating substrate (210).

8. The heat dissipation substrate according to any one of the preceding claims, wherein the bonding metal layer and the diffusion metal layer have a different thickness.

9. A power convertor including a power semiconductor module having the heat dissipation substrate according to any one of the preceding claims.

10. A method for manufacturing a heat dissipation substrate for a power semiconductor module, comprising:
providing an insulating substrate (210);
disposing a first bonding metal layer (215) on the insulating substrate (210);
disposing a first diffusion metal layer (220) on the first bonding metal layer (215);
arranging a metal plate (225) on the first diffusion metal layer (220);
performing a hot press process for bonding the metal plate (225) to the insulating substrate (210), wherein the first bonding metal layer (215) is converted to a second bonding metal layer (217), and the first diffusion metal layer (220) is converted to a second diffusion metal layer (223).

11. The method according to claim 10, wherein the second bonding layer (217) is formed by diffusion of material from the insulating substrate (210) into material of the first bonding layer (215); and/or
wherein the second diffusion metal layer (223) is formed by diffusion of material from the metal plate (225) into the first diffusion metal layer (220).

12. The method according to claim 10 or 11, wherein the second diffusion metal layer (223) includes an alloy of metal elements from the first diffusion metal layer (220) and from the metal plate (225).

13. The method according to claim 10, 11 or 12, wherein the hot press process comprises a compressing step and a heating step, and the compressing step is initiated before a bonding temperature is reached in the heating step.

14. The method according to claim 13, wherein the bonding temperature is equal to or higher than a melting point temperature of the first diffusion metal layer (220) at an exerted pressure of the compressing step.

15. The method according to any one of claims 10 to 14, wherein the first diffusion metal layer (220) is melted by pressure and/or temperature applied during the hot press process.
